# EUROPÄISCHE PATENTSCHRIFT

(11) **EP 1 464 077 B1**
(45) Veröffentlichungstag und Bekanntmachung des Hinweises auf die Patenterteilung: **08.11.2006**
(21) Anmeldenummer: 03706355.9
(22) Anmeldetag: 10.01.2003
(51) Int. Cl.: H01L 21/02

(54) **VERFAHREN ZUM HERSTELLEN EINES KONDENSATORS**
METHOD FOR PRODUCING A CAPACITOR
PROCEDE DE PRODUCTION D'UN CONDENSATEUR

(30) Priorität: 11.01.2002 DE 10200838
(43) Veröffentlichungstag der Anmeldung: 06.10.2004
(73) Patentinhaber: Infineon Technologies AG, 81669 München (DE)
(72) Erfinder: DAHL, Claus, 01109 Dresden (DE); STAHRENBERG, Knut, 01099 Dresden (DE); WILBERTZ, Christoph, 79194 Gundelfingen (DE)
(74) Vertreter: Schoppe, Fritz
(86) Internationale Anmeldenummer: PCT/EP2003/000184
(87) Internationale Veröffentlichungsnummer: WO 2003/058693

(56) Entgegenhaltungen:
- WO-A-00/54319
- DE-A- 10 107 012
- US-A- 5 391 905
- US-A1- 2001 009 785
- US-B1- 6 303 455
- PATENT ABSTRACTS OF JAPAN vol. 2000, no. 09, 13. Oktober 2000 (2000-10-13) & JP 2000 156467 A (NEC CORP), 6. Juni 2000 (2000-06-06)

## Beschreibung

Die vorliegende Erfindung bezieht sich auf Kondensatoren und insbesondere auf integrierte Kondensatoren mit Silizium bzw. Polysilizium-Elektroden.

Integrierte Schaltungen werden heutzutage in vielen Anwendungen und Vorrichtungen, beispielsweise für die drahtlose Kommunikation, verwendet. Um den heutzutage geforderten hohen Anforderungen bezüglich eines Verhaltens derartiger Vorrichtungen zu erfüllen, müssen die darin enthaltenen Bauelemente eine hohe Qualität aufweisen.

Der Intermodulationsfaktor und der Klirrfaktor stellen für die Anwendung einer analogen Schaltung bei einer drahtlosen Kommunikationsvorrichtung wichtige Parameter dar. Ein integrierter Kondensator, der beispielsweise bei einer analogen Schaltung für eine drahtlose Kommunikationsvorrichtung eingesetzt wird, sollte daher eine sehr geringe Abhängigkeit der Kapazität von der angelegten Spannung U aufweisen, um die oben erwähnten Anforderungen einer hochwertigen analogen Schaltung zu erreichen.

Der Kapazitätsverlauf C(U) wird im wesentlichen von Ladungsträgerkonzentrationen der beiden Kondensatorelektroden bestimmt, wobei die Ladungsträgerkonzentrationen möglichst hoch sein sollten. Ist beispielsweise eine obere Elektrode aus einer schwach n-dotierten Halbleiterschicht gebildet, so kann ein Anlegen von positiven Spannungen an dieser Elektrode zu einem starken Verarmen von Ladungsträgern in derselben führen. Da die Ausdehnung der gebildeten Verarmungszone von der angelegten Spannung abhängt, ergibt sich eine Spannungs-Abhängigkeit der Kapazität, die zu einem asymmetrischen Kapazitätsverlauf C(U) mit einer Abhängigkeit von der angelegten Spannung führt.

Diese nachteiligen Effekte können durch das Verwenden von Elektroden aus einem hochdotierten Halbleitermaterial oder vorteilhafter aus einem Metall vermieden werden.

Ferner sollte der Kondensator eine hohe Flächenkapazität aufweisen, um den Flächenverbrauch auf einem Chip gering zu halten, wobei Schwankungen der Flächenkapazität, die sich bei einer Herstellung des Kondensators ergeben, gering sein sollten.

Typischerweise wird ein integrierter Kondensator auf einem Chip zusammen mit anderen aktiven und passiven Bauelementen hergestellt. Bei einem Herstellungsprozeß ist ein Verfahren wünschenswert, bei dem ein integrierter Kondensator mit möglichst wenig zusätzlich Schritten in einen bestehenden integrierten Gesamtprozeß eingebunden werden kann. Die Anzahl von Prozeßschritten ist dabei von besonderer Bedeutung, da zusätzliche Prozeßschritte stets zusätzliche potentielle Quellen zur Erzeugung eines zusätzlichen Ausschusses bei einer Massenherstellung eröffnet. Daher ist für jeden integrierten Gesamtprozeß zu fordern, daß zur Herstellung unterschiedlicher Bauelemente, wie beispielsweise eines Kondensators und eines aktiven Bauelements, möglichst viele Herstellungsschritte gemeinsam verwendet werden. Mit der zunehmenden Miniaturisierung der Bauelemente auf einem Chip ist insbesondere die Anzahl von Phototechnik-Schritten von besonderer Bedeutung, da eine geringe Fehljustierung bei einem Phototechnik-Verfahren das herzustellende Bauelement funktionsunfähig macht. Insbesondere führt jede zusätzliche Phototechnik zu einer wesentlichen Erhöhung der Herstellungskosten.

Aufgrund der oben genannten Forderung einer geringen Anzahl von Zusatzschritten werden bekannterweise die Elektroden eines integrierten Kondensators durch Polysiliziumschichten gebildet, die in anderen Bereichen des Chips zum Erzeugen von Strukturen anderer Bauelemente verwendet werden, wobei eine zur Strukturierung der weiteren Bauelemente notwendige Phototechnik zur Strukturierung der Kondensatorelektroden verwendet wird. Beispielsweise wird bei einem bekannten Verfahren eine obere Elektrode eines integrierten Kondensators durch Strukturierung einer abgeschiedenen Polysiliziumschicht gebildet, wobei die Polysiliziumschicht ferner zur Bildung des Gates der CMOS-Transistoren verwendet wird.

Die oben erklärte Erzeugung der Elektrode weist jedoch den Nachteil auf, daß die Dotierstoffkonzentration der Polysiliziumschicht von dem Gesamtprozeß vorgegeben ist. Die typischerweise verwendeten Dotierstoffkonzentrationen von abgeschiedenen Schichten, die bei aktiven Bauelementen verwendet werden, sind nicht ausreichend, um eine Spannungsabhängigkeit der Kennlinie C(U) des Kondensators zu erreichen, die für ein hochwertiges Verhalten des Kondensators genügt.

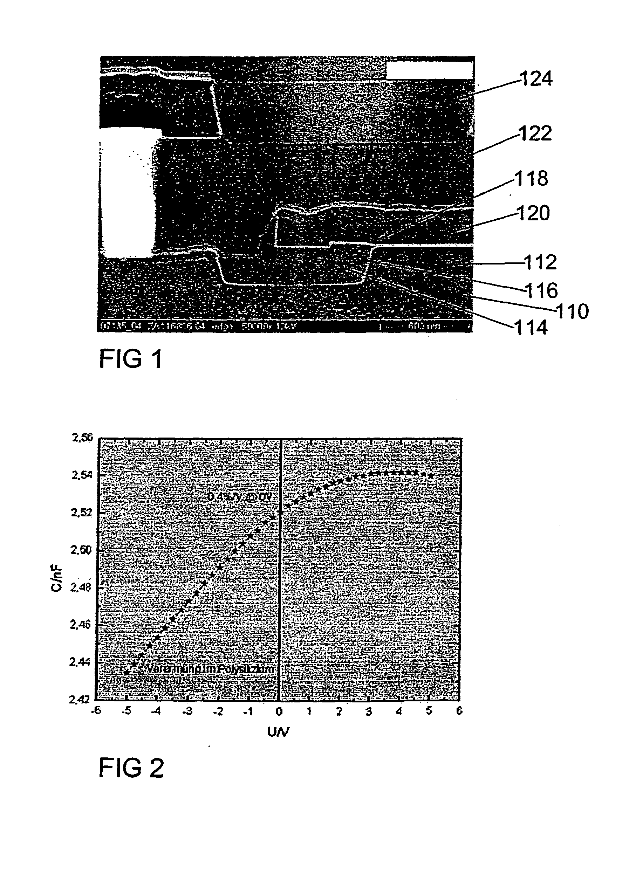

Fig. 1 zeigt einen Querschnitt eines bekannten integrierten Kondensators, bei dem die Dotierung der Kondensatorelektroden durch die Source/Drain-Dotierung der CMOS- (NMOS) Transistoren festgelegt ist. Gemäß Fig. 1 ist in einem Silizium-Substrat 110 ein hochleitender Bereich 112 als eine erste Elektrode des Kondensators gebildet. Der hochleitende Bereich 112 ist mit Phosphor als Dotierstoff auf eine Dotierstoffkonzentration von 6 x 10¹⁵ cm⁻³ dotiert und durch einen STI-Graben 114 (STI = shallow trench isolation = Flach-Graben-Isolation) von weiteren Bereichen des Substrats elektrisch isoliert. Auf dem hochleitenden Bereich 112 ist eine erste dielektrische Schicht 116 aus SiO₂ und eine zweite dielektrische Schicht 118 aus Si₃N₄ gebildet. Gemäß Fig. 1 weist die erste dielektrische Schicht aus SiO₂ eine Dicke von 4,6 nm auf, während die zweite dielektrische Schicht aus Si₃N₄ eine Dicke von 12 nm aufweist. Über der zweiten dielektrischen Schicht 118 ist als eine zweite Elektrode eine leitfähige Polysiliziumschicht 120 aufgebracht, die ferner in einem Bereich, der in Fig. 1 nicht gezeigt ist, zum Bilden eines aktiven Bauelements verwendet wird. Die Polysiliziumschicht 120 weist eine Dicke von 250 nm auf und ist mittels einer Arsen-Dotierung auf eine Dotierkonzentration von 5 x 10¹⁵ cm⁻³ dotiert. Über der Polysiliziumschicht 120 sind weitere Schichten 122 und 124 aufgebracht, die zur Kontaktierung der zweiten Elektrode verwendet werden.

Da bei dem in Fig. 1 gezeigten Kondensator die Dotierung der Kondensatorelektroden durch die Dotierschritte in einem CMOS-Transistorprozeß festgelegt ist, kann die Dotierung derselben nicht unabhängig gewählt werden, so daß mit den vorhandenen Dotierstoffkonzentrationen der Verlauf einer Kapazität über einer angelegten Spannung aufgrund einer Verarmung von Ladungsträgern im Polysilizium einen ungünstigen Verlauf zeigt, wie es nachfolgend erläutert wird.

Fig. 2 zeigt ein Diagramm einer Meßkurve des Kondensators von Fig. 1, der eine spezifische Kapazität von C = 3 fF/µm² aufweist. In Fig. 2 stellt eine x-Achse eine angelegte Spannung in Volt dar, während eine y-Achse eine Kapazität in nF anzeigt.

Wie es zu erkennen ist, weist der Kapazitätsverlauf des bekannten Kondensators von Fig. 1 in einem Bereich von +5 Volt bis +3 Volt einer zwischen der zweiten Elektrode aus Polysilizium und der ersten Elektrode angelegten Spannung einen im wesentlichen konstanten Verlauf auf, bei dem der Kapazitäts-wert etwa 2,54 nF beträgt. Mit abnehmender Spannung an der zweiten Elektrode aus Polysilizium zeigt der Kondensatorverlauf in einem Bereich von +3 Volt bis etwa -1 Volt eine nichtlineare Abnahme der Kapazität, die bei etwa -1 Volt in eine lineare Abnahme mit zunehmend angelegter negativer Spannung übergeht, wobei sich der Kapazitäts-Wert von etwa 2,51 nF bei -1 Volt auf etwa 2,43 nF bei -5 Volt verringert. In diesem Bereich, d.h. wenn die obere Elektrode aus Polysilizium positiv gegenüber der unteren Elektrode ist, bildet sich eine starke Raumladungszone im Polysilizium aus, deren Größe mit zunehmend angelegter negativer Spannung zunimmt.

Die in Fig. 2 gezeigte Kennlinie des Kapazitätsverlaufs ist folglich stark asymmetrisch und lediglich in einem kleinen Spannungsbereich konstant ausgebildet, weshalb sich der Kondensator von Fig. 1 nicht zur Realisierung eines hochwertigen Kondensators eignet, bei dem eine geringe Spannungs-Abhängigkeit der Kapazität verlangt ist. Eine bekannte Möglichkeit, die durch eine starke Verarmung der Ladungsträger in dem Polysilizium verursachte Spannungsabhängigkeit zu verbessern, besteht darin, die Dotierkonzentration des Polysiliziums der Polysiliziumschicht 120 nachträglich zu erhöhen.

Bekannterweise kann eine solche Erhöhung der aktiven Ladungsträger in der Polysiliziumschicht 120 durch eine Optimierung des Temperaturbudgets erreicht werden, wodurch sich eine leichte Verbesserung des Kapazitätsverlaufs erreichen läßt. Eine Veränderung des Temperaturbudgets kann jedoch nur in einem engen Bereich durchgeführt werden, da eine solche Veränderung nachteilige Einflüsse auf die Funktionalität der parallel zu dem Kondensator erzeugten CMOS-Transistoren hat.

Da bei dem oben beschriebenen integrierten Kondensator die Dotierung der Polysiliziumschicht 120 nicht unabhängig von dem Gesamtprozeß ist und spezieller durch eine Implantation erfolgt, die gleichzeitig eine Dotierung der Source/Drain-Bereiche der CMOS-(NMOS-)Transistoren durchführt, kann die Dotierung der Polysiliziumschicht 120 bei dem oben beschriebenen Kondensator nicht zu hoch gewählt werden, da eine zu hohe Dotierung der Source/Drain-Bereiche zu einem Durchbruch der NMOS-Transistoren führen würde.

Verbesserungen in der Spannungsabhängigkeit lassen sich bekannterweise mit einer Nach-Dotierung der aufgebrachten Polysiliziumschichten erreichen. Dies kann beispielsweise durch eine nachträgliche Ionenimplantation, die bei n-leitenden Elektroden vorzugsweise eine Phosphor-Implantation umfaßt, erfolgen. Die nachträgliche Dotierung weist jedoch den Nachteil auf, daß zusätzliche Verfahrensschritte, insbesondere zusätzliche Phototechnik-Schritte, notwendig sind, um die nachträgliche Implantation durchzuführen. Wie vorhergehend erwähnt wurde, verteuert jede zusätzliche Phototechnik den Gesamtprozess sehr stark.

Ferner ist es bekannt, einen Speicherkondensator bzw. Tief-Graben-Kondensator (Deep-Trench-Kondensator) als integrierten Kondensator auf dem Chip vorzusehen, um einen günstigen Kapazitätsverlauf C(U) zu erreichen. Das Vorsehen eines Speicherkondensators weist jedoch den Nachteil auf, daß zur Erzeugung desselben eine komplexe Prozessierung mit zusätzlichen Prozeßschritten erforderlich ist, die das Erzeugen des Tief-Grabens und ein nachfolgendes Auffüllen umfaßt. Diese komplexen Prozeßschritte wirken sich bei einer Massenherstellung wiederum nachteilig auf den Ausschußanteil aus. Ferner ist bei einem Speicherkondensator aufgrund der komplexen Anordnung desselben in einem Graben eine spezifische Flächenkapazität im Vergleich zu einem herkömmlichen planaren Kondensator lediglich schlecht reproduzierbar.

Ein weiterer bekannter Ansatz, einen integrierten Kondensator mit günstigem Kapazitätsverlauf zu erzeugen, besteht darin, die Elektroden des Kondensators als metallische Schichten zu bilden. Bei einem solchen Kondensator mit Metallelektroden, der als ein MIM-Kondensator bezeichnet wird, ergibt sich aufgrund der hohen Leitfähigkeit der Elektroden eine sehr geringe Spannungs-Abhängigkeit des Kapazitätsverlaufs. Die MIM-Kondensatoren weisen jedoch den Nachteil auf, daß das zwischen den Metallelektroden angeordnete Dielektrikum mit denselben verträglich sein muß, d.h. die Abscheidung der Dielektrika kann nur bis zu einer für die Metallelektroden verträglichen Temperatur erfolgen. Die bekannten Dielektrika, die diese Anforderung erfüllen, weisen jedoch eine Dielektrizitätszahl auf, die geringer als diejenige von bekannten Dielektrika ist, die für Polysiliziumschichten verwendet werden können. Folglich ist die Flächenkapazität eines MIM-Kondensators im Vergleich zu anderen Typen von integrierten Kondensatoren reduziert.

Ausgehend von diesem Stand der Technik besteht die Aufgabe der vorliegenden Erfindung darin, ein verbessertes Verfahren zur Herstellung eines integrierten Kondensators mit vorteilhaftem Verhalten zu schaffen.

Diese Aufgabe wird durch ein Verfahren nach Anspruch 1 gelöst.

Die vorliegende Erfindung schafft ein Verfahren zum Herstellen eines Kondensators mit folgenden Schritten:

Bereitstellen einer Rohstruktur mit einem Substrat und wenigstens einer dielektrischen Schicht, wobei ein erster Bereich und ein zweiter Bereich des Substrats durch eine isolierende Struktur getrennt sind;

Aufbringen einer elektrisch leitfähigen Schicht auf die wenigstens eine dielektrische Schicht oberhalb des ersten und zweiten Bereichs;

Aufbringen einer Maskenschicht auf die elektrisch leitfähige Schicht und Strukturieren derselben zur Erzeugung einer ersten Maske oberhalb des ersten Bereichs;

Wegätzen der elektrisch leitfähigen Schicht und zumindest einer der dielektrischen Schichten im zweiten Bereich mittels der Maske; und

Fertigprozessieren eines aktiven Elements im zweiten Bereich.

Die vorliegende Erfindung basiert auf der Erkenntnis, daß ein verbessertes Verfahren zum Herstellen eines Kondensators erreicht wird, indem eine obere Elektrode des Kondensators eine leitfähige Schicht aufweist, die nach einem Strukturieren lediglich in einem Kondensatorbereich gebildet ist, wobei bei dem erfindungsgemäßen Strukturieren eine Maske verwendet wird, die nachfolgend ebenfalls zum Strukturieren des Dielektrikums des Kondensators verwendet wird. Das erfindungsgemäße Verfahren, bei dem die Erzeugung der oberen Elektrode durch das erfindungsgemäße Strukturieren derselben von einer Erzeugung weiterer aktiver Elemente in Bereichen außerhalb des Kondensatorbereichs entkoppelt ist, ermöglicht, daß die leitfähige Schicht mit einer gewünschten Leitfähigkeit aufgebracht werden kann, ohne die Erzeugung der aktiven Elemente zu stören, wobei jedoch keine zusätzliche Phototechnik erforderlich ist, da die Maske zum Strukturieren der leitfähigen Schicht auch zum Strukturieren des Dielektrikums verwendet wird.

Die vorliegende Erfindung weist den Vorteil auf, daß durch ein Erzeugen der leitfähigen Schicht mit einer hohen Leitfähigkeit ein auf einem Chip integrierter Kondensator erzeugbar ist, der eine geringe Abhängigkeit der Kapazität von einer angelegten Spannung aufweist, ohne daß weitere auf dem Chip angeordnete aktive Elemente beeinflußt werden.

Insbesondere kann bei einem Ausführungsbeispiel, bei dem die leitfähige Schicht aus einem Metall gebildet ist, ein sehr gutes Verhalten des Kondensators mit geringer Spannungsabhängigkeit der Kapazität erhalten werden.

Ferner weist die vorliegende Erfindung den Vorteil auf, daß durch das Entfernen der leitfähigen Schicht in Bereichen außerhalb des Kondensatorbereichs eine Erhöhung von Strukturen in denselben vermieden wird.

Das Entfernen der leitfähigen Schicht außerhalb des Kondensatorbereichs ermöglicht ferner eine Eingliederung des Verfahrens in ein bestehendes Herstellungsverfahren zum parallelen Erzeugen eines integrierten Kondensators und integrierter aktiver Elemente ohne dabei zusätzliche Phototechnikschritte zu benötigen.

Ferner kann bei einem Ausführungsbeispiel die leitfähige Schicht eine hochdotierte Polysiliziumschicht umfassen, wodurch für die dielektrische Schicht ein Dielektrikum mit hoher Dielektrizitätszahl gewählt werden kann, so daß der hergestellte Kondensator eine hohe Flächenkapazität bei gleichzeitig gutem Verhalten aufweist.

Bevorzugte Ausführungsbeispiele der vorliegenden Erfindung werden nachfolgend Bezug nehmend auf die beiliegenden Zeichnungen näher erläutert. Es zeigen:
Fig. 1 einen Querschnitt eines bekannten integrierten Kondensators;
Fig. 2 einen Verlauf einer Kapazität des bekannten Kondensators von Fig. 1 als Funktion einer angelegten Spannung;
Fig. 3-17 schematische Querschnittansichten zur Darstellung von Prozeßschritten zur Herstellung eines Kondensators gemäß eines ersten Ausführungsbeispiels der vorliegenden Erfindung;
Fig. 18-19 schematische Querschnittansichten zur Darstellung von Prozeßschritten zur Herstellung eines Kondensators gemäß eines zweiten Ausführungsbeispiels der vorliegenden Erfindung; und
Fig. 20-23 schematische Querschnittansichten zur Darstellung von Prozeßschritten zur Herstellung eines Kondensators gemäß eines dritten Ausführungsbeispiels der vorliegenden Erfindung.

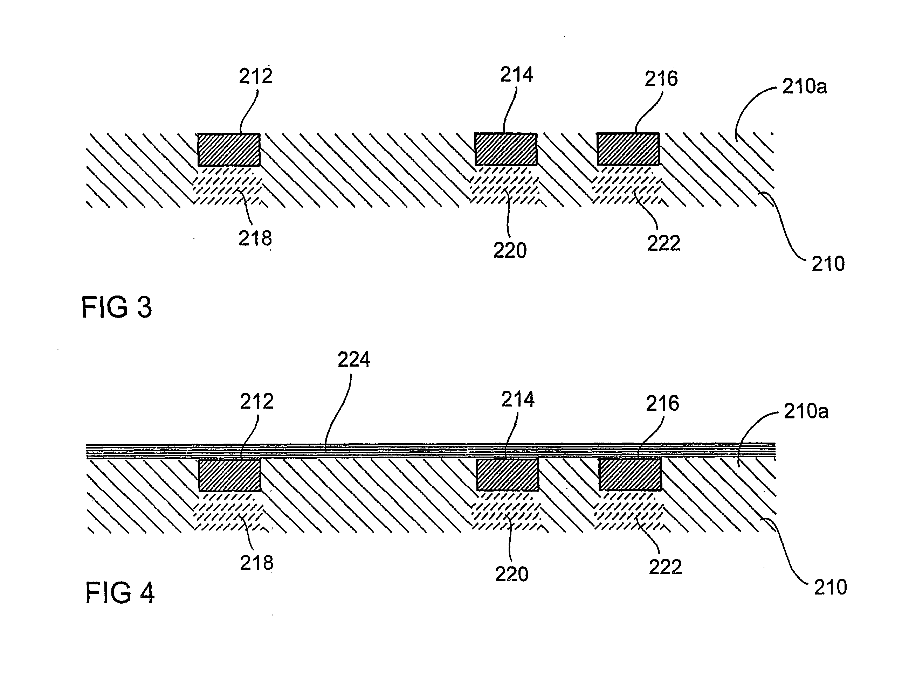

Unter Bezugnahme auf die Fig. 3-23 werden nachfolgend verschiedene Ausführungsbeispiele der vorliegenden Erfindung erklärt. In den Figuren sind gleichartige Elemente und Bereiche jeweils durch gleiche Bezugszeichen gekennzeichnet.

In den folgenden Figuren sind jeweils Querschnittdarstellungen gezeigt, die einen Ausschnitt eines Substrats 210 umfassen. In dem gezeigten Ausschnitt ist ein Kondensatorbereich dargestellt; in dem durch das erfindungsgemäße Verfahren ein Kondensator gebildet wird. Ferner sind Abschnitte von Bereichen dargestellt, die an den Kondensatorbereich angrenzen. Obwohl es in den Figuren nicht gezeigt ist, umfaßt das Substrat ferner weitere Abschnitte oder Bereiche, in denen andere Bauelemente, wie beispielsweise ein MOS-Transistor oder ein Bipolartransistor gebildet werden.

Im folgenden wird unter Bezugnahme auf die Fig. 3-17 ein erstes Ausführungsbeispiel erklärt. Fig. 3 zeigt eine Halbleiterstruktur nach dem Durchführen von Herstellungsschritten, bei denen in einem Halbleitersubstrat 210 aus Silizium auf einer Oberfläche 210a zunächst drei STI-Isolationsbereiche (STI = shallow trench isolation) gebildet werden. Das Siliziumsubstrat 210 weist in Bereichen, in denen die STI-Isolationsbereiche 212, 214 und 216 nicht gebildet sind, eine hohe Dotierstoffkonzentration auf, wobei die Dotierung des zunächst undotierten Substrats 210 durch eine Implantation von Phosphor als Dotierstoff über die Oberfläche 210a erfolgt, nachdem die STI-Isolationsbereiche erzeugt sind. In Bereichen unterhalb der STI-Isolationsbereiche 212, 214 und 216 sind unterdiffundierte Bereiche 218, 220 und 222 mit geringer Leitfähigkeit gebildet, die durch eine laterale Diffusion des Dotierstoffs während der Implantation entstehen. Durch die STI-Isolationsbereiche 212 und 214 ist ein Kondensatorbereich definiert, in dem ein integrierter Kondensator durch das erfindungsgemäße Verfahren gebildet wird. Der Kondensatorbereich umfaßt einen Bereich zwischen den STI-Isolationsbereichen 212 und 214. Der Kondensatorbereich ist durch die STI-Isolationsbereiche 212, 214 von angrenzenden Bereichen des Substrats elektrisch isoliert.

Obwohl bei den beschriebenen Ausführungsbeispielen lediglich eine elektrische Isolierung von Substratbereichen durch STI-Isolationsbereiche gezeigt ist, können bei anderen Ausführungsbeispielen andere elektrische Isolierungen von Substratbereichen vorgesehen sein. Ferner ist die Dotierung des Substrats nicht auf die beschriebene Ionenimplantation nach dem Erzeugen der elektrischen Isolierung beschränkt. Beispielsweise kann das Substrat durch jede bekannte Dotiertechnik ganzflächig dotiert werden, wobei eine elektrische Isolierung von Substratbereichen beispielsweise durch eine Tief-Graben-Isolierung (Deep-Trench-Isolation) erreicht wird.

Fig. 4 zeigt die Struktur von Fig. 3 nach dem ganzflächigen Aufbringen einer ersten dielektrischen Schicht 224 aus Si₃N₄, wobei dieselbe mit einer Dicke von etwa 4-6 nm auf der Oberfläche 210a des Substrats 210 aufgebracht wird.

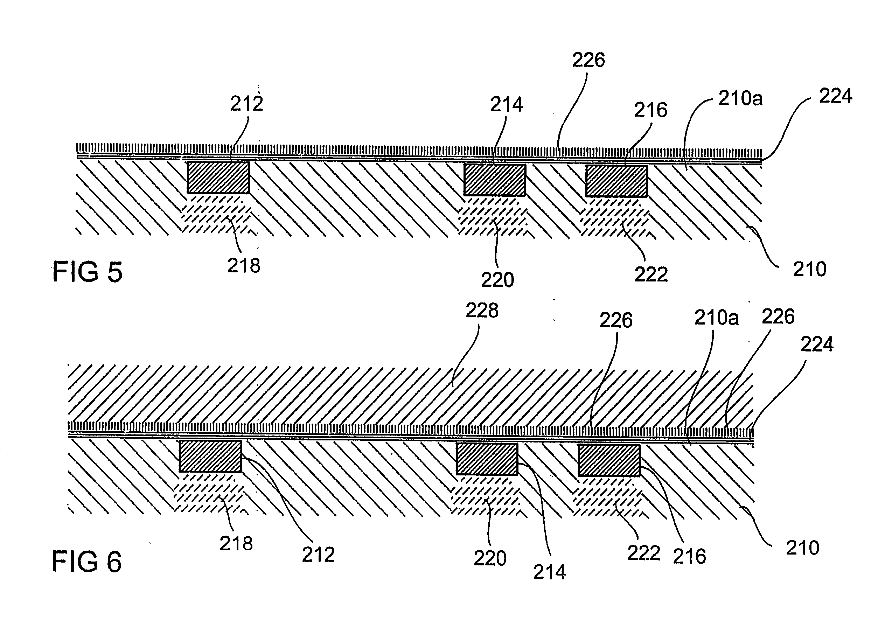

Unter Bezugnahme auf Fig. 5 wird ausgehend von der Struktur von Fig. 4 auf der ersten dielektrischen Schicht 224 eine zweite dielektrische Schicht 226 ganzflächig auf der ersten dielektrischen Schicht 224 aufgebracht. Bei dem beschriebenen Ausführungsbeispiel weist die zweite dielektrische Schicht 226 SiO₂ auf, die durch eine Re-Oxidation erzeugt wird. Die Gesamtdicke der Struktur, die die erste und zweite dielektrische Schicht umfaßt, beträgt dabei etwa 5-7 nm. Alternativ kann anstatt den beschriebenen zwei dielektrischen Schichten bei anderen Ausführungsbeispielen lediglich eine dielektrische Schicht auf der Oberfläche 210a des Substrats 210 als Kondensatordielektrikum aufgebracht werden, wobei die Schicht ferner nicht auf die beschriebenen Dielektrika Si₃N₄ und SiO₂ beschränkt ist und jedes bekannte Dielektrikum umfassen kann. Ebenso kann anstatt den dielektrischen Schichten 224 und 226 eine Schichtstruktur mit mehr als zwei dielektrischen Schichten bzw. Lagen aufgebracht werden, wobei die Schichtstruktur jede mögliche Kombination von bekannten Dielektrika umfassen kann.

Unter Bezugnahme auf Fig. 6 wird in der in Fig. 5 gezeigten Struktur eine leitfähige Schicht 228 ganzflächig auf die zweite dielektrische Schicht 226 aufgebracht. Die leitfähige Schicht 228 umfaßt bei einem bevorzugten Ausführungsbeispiel Polysilizium, das vorzugsweise mit Phosphor stark dotiert ist. Typische Dotierkonzentrationen umfassen einen Bereich von 1 x 10²⁰ cm⁻³ bis 4 x 10²⁰ cm⁻³. Das Aufbringen der leitfähigen Schicht 228 kann durch jedes bekannte Verfahren, wie beispielsweise durch eine chemische Dampfabscheidung mit niedrigem Druck (LPCVD; LPCVD = Low Pressure Chemical Vapor Deposition), erfolgen. Vorzugsweise weist die leitfähige Schicht 228 eine Dicke von etwa 100 nm auf und ist bei dem beschriebenen Ausführungsbeispiel mit Phosphor als Dotierstoff n-dotiert. Die Dotierung kann durch ein In-situ-Verfahren während der Abscheidung der Schicht, durch ein Dotieren aus der Gasphase, durch eine ganzflächige Implantation oder durch jedes andere bekannte Dotierverfahren erfolgen.

Bei einem alternativen Ausführungsbeispiel kann die leitfähige Schicht 228 als metallische Schicht aufgebracht werden, wobei das verwendete Metall vorzugsweise hochtemperaturbeständig ist, um ein Schmelzen während nachfolgender Verfahrensschritte zu vermeiden. Die metallische Schicht ist mit jedem bekannten Verfahren, wie beispielsweise einem SputterVerfahren oder einer Aufdampfung, aufbringbar.

Die leitfähige Schicht 228 kann mit jeder gewünschten Dotierung bzw. Leitfähigkeit versehen werden. Ferner kann die leitfähige Schicht 228 bei anderen Ausführungsbeispielen auch mehrere Lagen mit unterschiedlichen Materialien und Dotierungen umfassen.

Wie es nachfolgend erklärt wird, beeinflußt die Aufbringung der leitfähigen Schicht 228 die Bildung vorgesehener anderer Bauelemente, wie beispielsweise MOS-Transistoren und Bipolar-Transistoren in Bereichen außerhalb des Kondensatorbereichs nicht, da dieselbe in einem nachfolgenden Schritt in den Bereichen außerhalb des Kondensatorbereichs vor dem Fertigprozessieren der Bauelemente entfernt wird.

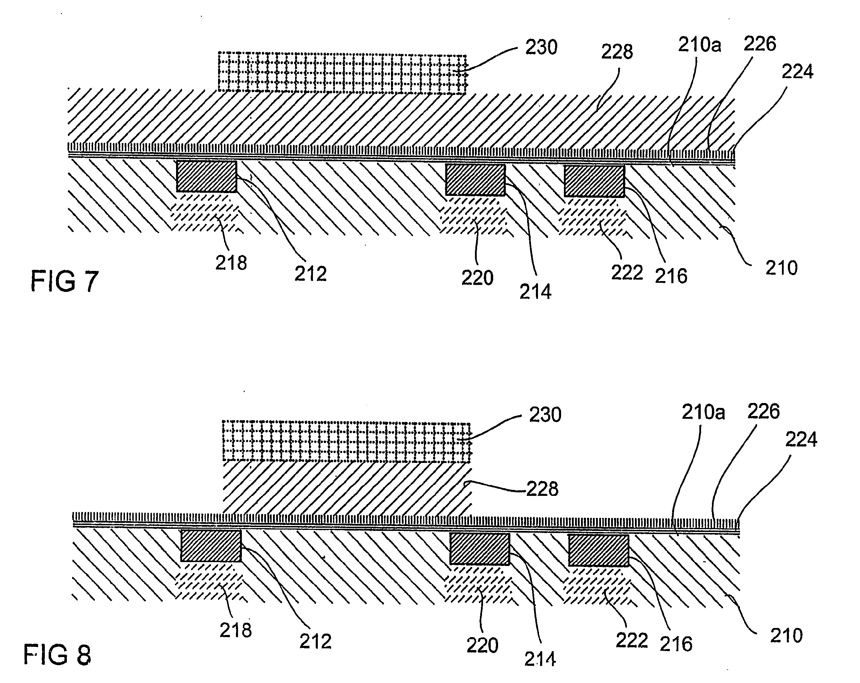

Fig. 7 zeigt die Struktur von Fig. 6 nach einem Durchführen eines Photolithographieschrittes zum Erzeugen einer Maske 230 zum Ätzen der leitfähigen Schicht 228. Vorzugsweise wird die Maske 230 aus TEOS-Material (TEOS = Tetra-Ethyl-Ortho-Silikat) mit einer Dicke von 30 nm auf der leitfähigen Schicht 228 abgeschieden und daraufhin mittels bekannter Lithographietechniken, wie beispielsweise einer Photolithographie, und bekannter Ätzverfahren, wie beispielsweise einem Plasmaätzen, zu der Maske 230 strukturiert. Wie es in Fig. 6 zu erkennen ist, erstreckt sich die Maske 230 nach dem Strukturieren in dem Bereich zwischen den STI-Isolationsbereichen 212, 214 und jeweils teilweise in die Isolationsbereiche 212 und 214, um in einem nachfolgenden Schritt die leitfähige Schicht 228 so zu strukturieren, daß dieselbe lediglich in dem Kondensatorbereich gebildet ist.

Alternativ kann die Maske 230 andere Materialen umfassen, die geeignet sind, ein Strukturieren der leitfähigen Schicht 228 und zumindest der aufgebrachten zweiten dielektrischen Schicht 226 durchzuführen. Ebenso kann die Maske 230 eine Schichtstruktur mit mehreren Schichten aufweisen, die unterschiedliche Materialien aufweisen.

In einem nachfolgenden Schritt wird die leitfähige Schicht 228 unter Verwendung der Maske 230 in dem Bereich entfernt, der nicht durch die Maske 230 bedeckt ist, so daß aus der leitfähigen Schicht 228 eine strukturierte leitfähige Schicht 228 erzeugt wird, die lediglich in dem Kondensatorbereich gebildet ist. Bei einem Ausführungsbeispiel, bei dem die leitfähige Schicht 228 aus Polysilizium besteht, erfolgt das Entfernen der leitfähigen Schicht 228 außerhalb des Kondensatorbereichs mittels geeigneter bekannter Ätztechniken, wie beispielsweise durch ein Plasmaätzen.

Vorzugsweise kann zur Ätzung der leitfähigen Schicht 228 ein Ätzverfahren verwendet werden, bei dem die zweite dielektrische Schicht 226 als ein Ätzstopp wirkt, um ein weiteres Ätzen durch die dielektrischen Schichten 224 und 226 in das Substrat 210 zu verhindern. Um ein solches selektives Ätzen zu ermöglichen, kann das Ätzverfahren an die' dielektrische Schicht 226 angepaßt sein oder umgekehrt die dielektrische Schicht 226 entsprechend zu dem Ätzverfahren gewählt werden.

Fig. 8 zeigt die Struktur von Fig. 7 nach der Durchführung des Ätzschrittes. Die strukturierte leitfähige Schicht 228, die nach dem Ätzschritt lediglich in dem Bereich unterhalb der Maske 230 gebildet ist, erstreckt sich über den Kondensatorbereich, der den Bereich von dem Isolationsbereich 212 zu dem Isolationsbereich 214 umfaßt.

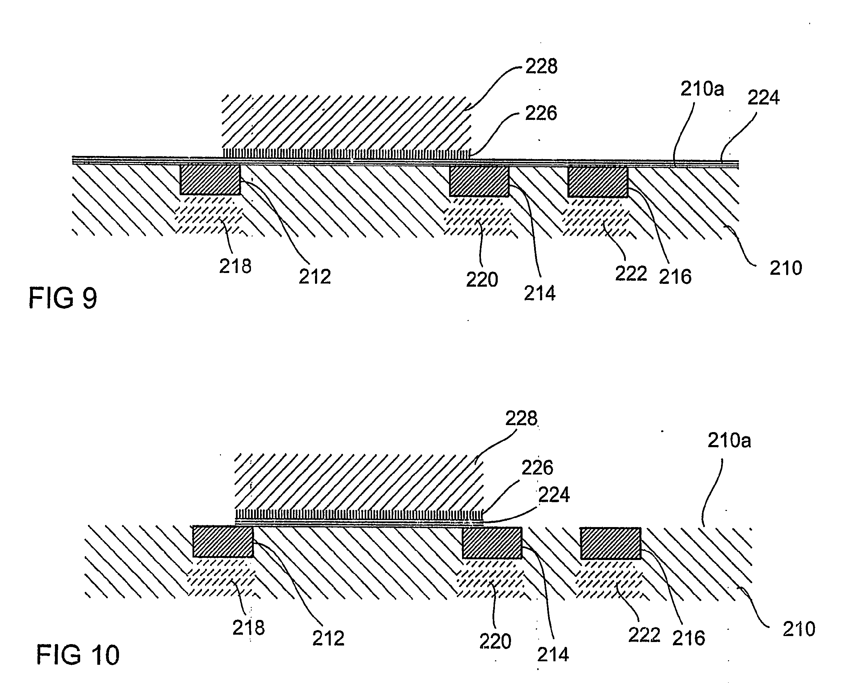

In einem darauffolgenden Schritt wird ein Ätzen der zweiten dielektrischen Schicht 226 aus SiO₂ unter Verwendung der Schicht 228 als Maske 230 durchgeführt. Fig. 9 zeigt die Struktur von Fig. 8 nach dem Durchführen dieses Ätzschrittes. Entsprechend zu der strukturierten leitfähigen Schicht 228 ist die zweite dielektrische Schicht 226 nach dem Durchführen des Ätzvorgangs in dem Kondensatorbereich gebildet, während in einem Bereich außerhalb des Kondensatorbereichs, die zweite dielektrische Schicht 226 entfernt ist. Das Ätzen der zweiten dielektrischen Schicht 226, die bei dem beschriebenen Ausführungsbeispiel aus SiO₂ gebildet ist, erfolgt vorzugsweise durch ein Ätzverfahren, bei dem die erste dielektrische Schicht 224, die bei dem beschriebenen Ausführungsbeispiel aus Si₃N₄ gebildet ist, als eine Ätzstopp-Schicht wirkt, so daß ein Überätzen in das Substrat 210 hinein vermieden wird. Bei dem beschriebenen Ausführungsbeispiel wird durch das Ätzen der zweiten dielektrischen Schicht 226 die Maske 230 entfernt, wobei die strukturierte leitfähige Schicht 228 nicht geätzt wird, da dieselbe bei dem Ätzverfahren ebenfalls als eine Ätzstopp-Schicht wirkt.

In einem darauffolgenden Schritt wird unter Bezugnahme auf Fig. 10 die erste dielektrische Schicht 224 in einem Bereich außerhalb der strukturierten leitfähigen Schicht 228 weggeätzt. Fig. 10 zeigt die Struktur von Fig. 9 nach dem Durchführen dieses Ätzschrittes. Wie in Fig. 10 zu erkennen ist, ist die erste dielektrische Schicht 224 nach dem Ätzen so strukturiert, daß sich dieselbe entsprechend zu der zweiten dielektrischen Schicht 226 lediglich über den Kondensatorbereich erstreckt. Bei dem beschriebenen Ausführungsbeispiel wird die strukturierte leitfähige Schicht 228 aus Polysilizium als eine Ätzmaske zur Strukturierung der ersten dielektrischen Schicht 224 aus Si₃N₄ verwendet. Ebenso wirkt bei dem Ätzen der ersten dielektrischen Schicht 224 aus Si₃N₄ das Substrat 210 aus Silizium als ein Ätzstopp, so daß ein Überätzen in das Substrat 210 vermieden wird. Folglich ist bei dem beschriebenen Ausführungsbeispiel durch das geeignete Auswählen der dielektrischen Schicht 224 aus Si₃N₄ und der dielektrischen Schicht 226 aus SiO₂ eine selektive Ätzung ermöglicht, wobei bei einer Ätzung der zweiten dielektrischen Schicht 226 die erste dielektrische Schicht 224 als eine Ätzstopp-Schicht wirkt und bei einer Ätzung der ersten dielektrischen Schicht 224 die strukturierte leitfähige Schicht 228 und das Substrat 210 als ein Ätzstopp wirken. Die selektive Ätzung ermöglicht ein exaktes Entfernen der dielektrischen Schichten 224 und 226, ohne die Gefahr eines Abtragens der strukturierten leitfähigen Schicht 228 und des Substrats 210.

Die vorliegende Erfindung ist nicht auf das oben erklärte Strukturierungs- und Ätzverfahren beschränkt, um die erfindungsgemäße Strukturierung der leitfähigen Schicht 228 und der dielektrischen Schichten 224 und 226 unter Aufbringung und Strukturierung lediglich einer Maske 230 zu erreichen. Beispielsweise kann die aufgebrachte Maske 230 mehrere Schichten umfassen, wobei bei Ätzvorgängen zur Strukturierung der leitfähigen Schicht 228 und der dielektrischen Schichten 224 und 226 jeweils eine der Schichten unter Verwendung der darunterliegenden Schicht als Ätzstopp abgeätzt wird.

Nach dem oben beschriebenen Ätzen wird eine Reinigung durchgeführt, um eventuell verbleibende störende Reste und Verschmutzungen zu beseitigen. In nächfolgenden Schritten werden in einem MOS-Bereich und in einem Bipolar-Bereich außerhalb des Kondensatorbereichs Prozeßschritte zur Erzeugung von einem oder mehreren CMOS-Transistoren und/oder einem oder mehreren Bipolar-Transistoren durchgeführt, wobei derselbe in den Darstellungen der Fig. 1 - 23 nicht gezeigt ist. Wie es nachfolgend erklärt wird, werden bestimmte Prozeßschritte zur Erzeugung der aktiven Elemente, wie beispielsweise eine Aufbringung von Schichten oder Masken, ein Dotieren oder ein Strukturieren, parallel in dem Kondensatorbereich durchgeführt, um einen elektrischen Anschluß an die strukturierte leitfähige Schicht 228 herzustellen. Dabei können in verschiedenen Ausführungsbeispielen unterschiedliche Prozeßschritte des Prozeßverlaufs in dem Kondensatorbereich zur Erzeugung von Anschlüssen oder anderer Strukturen verwendet werden.

Zunächst wird unter Verwendung bekannter Techniken, die Lithographietechniken und Dotiertechniken umfassen, p- und n-Wannen zur elektrischen Isolierung von nachfolgend erzeugten Source- und Drainbereichen in dem MOS-Bereich gebildet. Daraufhin wird die Oberfläche der Struktur durch eine HF-Reinigung gereinigt und eine Oxid-Schicht 232 auf der Oberfläche der Struktur gebildet. Die Oxidschicht 232 dient in dem MOS-Bereich nach der Strukturierung derselben als eine Gate-Oxidschicht und wird mittels bekannter Techniken zur Erzeugung von Gate-Oxidschichten gebildet.

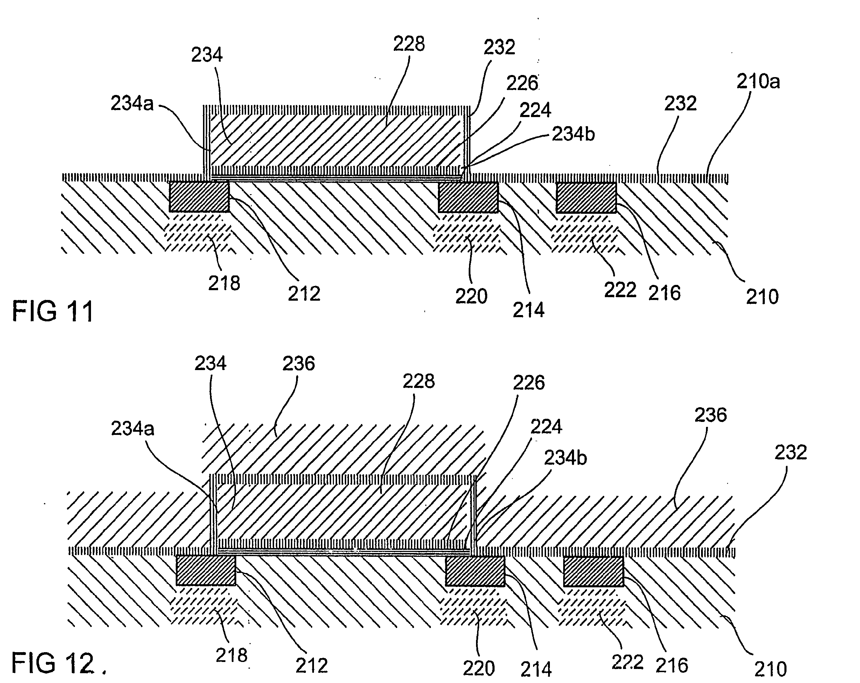

Fig. 11 zeigt die Struktur von Fig. 10 nach dem Bilden der Oxidschicht 232. In einem Bereich außerhalb einer durch die strukturierten Schichten 224, 226 und 228 definierten Kondensatorstruktur 234 erstreckt sich die Oxidschicht 232 auf der Oberfläche 210a des Silizium-Substrats 210. Ferner erstreckt sich die Oxidschicht 232 auf der strukturierten leitfähigen Schicht 228 sowie an Seitenflächen 234a und 234b der Kondensatorstruktur 234.

Unter Bezugnahme auf Fig. 12 wird daraufhin bei dem ersten Ausführungsbeispiel eine Polysiliziumschicht 236 auf der Oxidschicht 232 aufgebracht, wobei die Polysiliziumschicht 236 ferner in dem MOS-Bereich zur Bildung einer Gate-Elektrode aufgebracht wird. Fig. 12 zeigt die in Fig. 11 dargestellte Struktur nach dem Aufbringen der Polysiliziumschicht 236. Die Aufbringung der Polysiliziumschicht 236 kann mit jedem geeigneten Verfahren, wie beispielsweise einem LPCVD-Verfahren durchgeführt werden. Vorzugsweise wird die Polysiliziumschicht 236 undotiert aufgebracht und bei einem späteren Dotierschritt, der in dem MOS-Bereich eine Dotierung von Source- und Drain-Bereichen der MOS-Transistoren festlegt, mittels Ionenimplantation dotiert. In einem darauffolgenden Schritt wird eine Strukturierung der Polysiliziumschicht 236 durchgeführt. Dazu wird eine Maskenschicht (nicht gezeigt) aufgebracht und mittels bekannter Phototechnik- und Ätzverfahren strukturiert. Die Strukturierungen erfolgen analog zu der Strukturierung eines Bipolartransistors in einem Bipolar-Bereich des Substrats, wobei der Bipolartransistor in den Darstellungen der Fig. 1 - 23 nicht gezeigt ist.

Die strukturierte Maske in dem Kondensatorbereich wird anschließend verwendet, um die auf der strukturierten leitfähigen Schicht 228 gebildete Polysiliziumschicht 236 zu entfernen. Durch die Verwendung einer geeigneten Phototechnik wird ferner in Bereichen, die an die Seitenflächen 234a und 234b der Kondensatorstruktur angrenzen, die Polysiliziumschicht 236 teilweise entfernt.

Das Entfernen der Polysiliziumschicht 236 ist notwendig, um in einem nachfolgenden Schritt die Oxidschicht 232 auf der Oberfläche der strukturierten leitfähigen Schicht 228 zu entfernen und einen elektrischen Kontakt für die strukturierte leitfähige Schicht 228 zu ermöglichen. Bei der Ätzung der Oxidschicht 232 mittels Flußsäure wird ferner die Oxidschicht 232, die an den Seitenflächen 234a und 234b der Kondensatorstruktur 234 gebildet ist, bei dem obigen Ätzschritt teilweise entfernt.

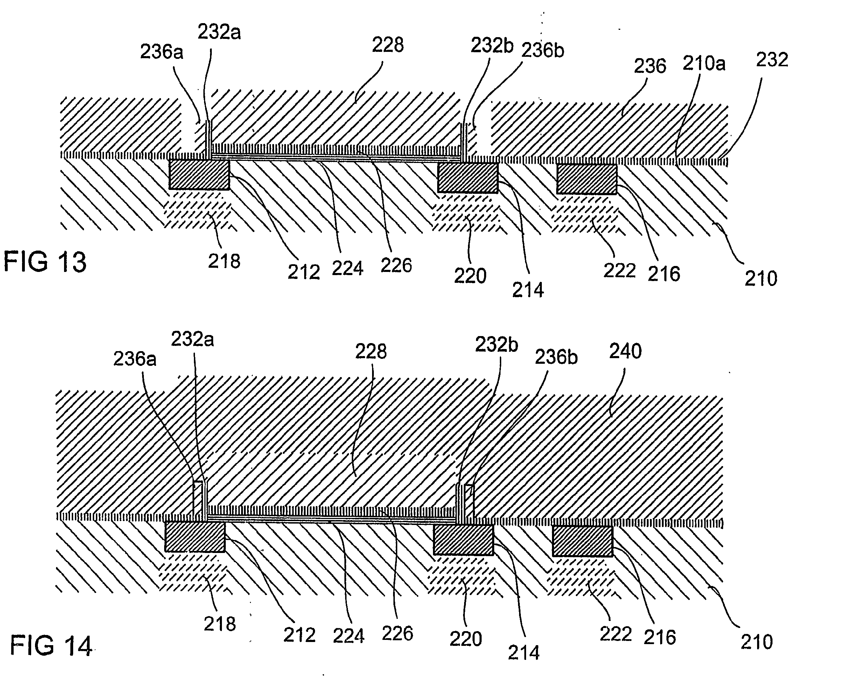

Fig. 13 zeigt die Struktur von Fig. 12 nach dem Durchführen der oben beschriebenen Schritte. Durch die Prozessführung, die das Ätzen der Polysiliziumschicht 236 und der Oxidschicht 232 umfaßt, sind Oxidschichtbereiche 232a und 232b gebildet, die sich, ausgehend von der Oxidschicht 232, die auf der Oberfläche 210a angeordnet ist, teilweise entlang den Bereichen erstrecken, die seitlich an die Kondensatorstruktur 234 angrenzen. Gemäß Fig. 13 erstreckt sich die Polysiliziumschicht 236 ferner in Bereichen außerhalb des Kondensatorbereichs. Ferner sind seitlich auf den Oxidschichtbereichen 232a und 232b Polysiliziumschichtbereiche 236a und 236b gebildet.

In einem nachfolgenden Schritt wird eine zweite Polysiliziumschicht 240 abgeschieden, die in dem Bipolar-Bereich zur Bildung einer Basisanschlußschicht aus Polysilizium für einen dort vorgesehenen Bipolartransistor vorgesehen ist. Fig. 14 zeigt die Struktur von Fig. 13 nach dem Durchführen dieses Schrittes. Wie es zu erkennen ist, ist die zweite Polysiliziumschicht 240 ganzflächig auf einer Oberfläche der Struktur von Fig. 13 aufgebracht. Die Aufbringung erfolgt beispielsweise durch eine LPCVD-Aufbringung, wobei die zweite Polysiliziumschicht 240 eine Dicke von 150 nm aufweist. Vorzugsweise wird die zweite Polysiliziumschicht 240 undotiert aufgebracht, um in einem nachfolgenden Schritt mittels Ionenimplantation dotiert zu werden.

In einem nachfolgenden Schritt wird unter Verwendung einer Photolithographie ein Ätzen der zweiten Polysiliziumschicht 240 durchgeführt.

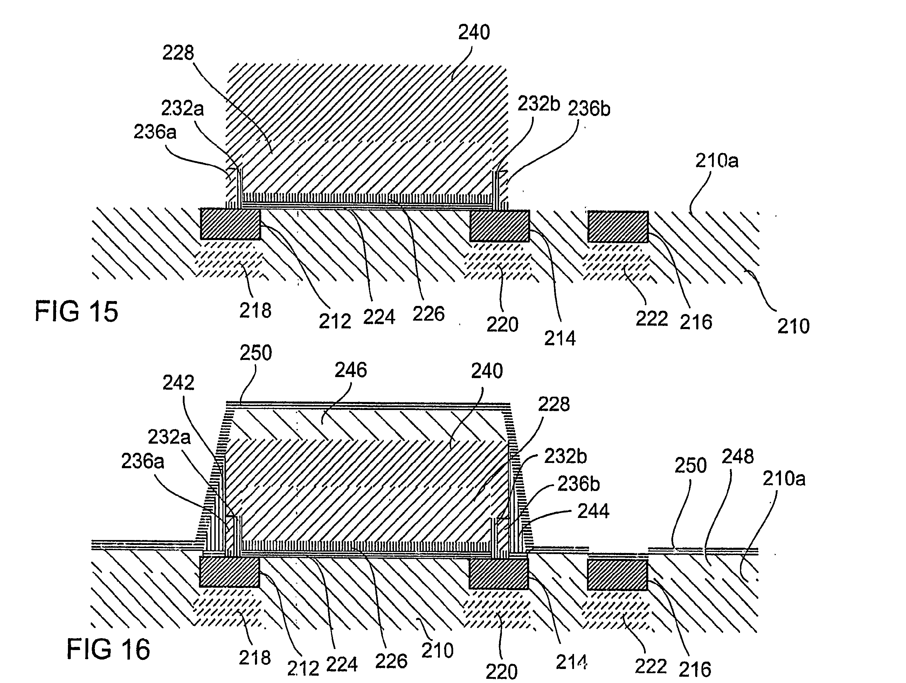

Fig. 15 zeigt die Struktur von Fig. 14 nach dem Durchführen der Ätzung. Wie es zu erkennen ist, verbleibt die zweite Polysiliziumschicht 240 nach der Ätzung auf der leitfähigen Schicht 228 sowie oberhalb der Oxidschichtbereiche 232a und 232b und der Polysiliziumschichtbereiche 238a und 238b. Daraufhin wird in Bereichen, in denen die zweite Polysiliziumschicht 240 entfernt ist, die auf dem Substrat aufgebrachte Oxidschicht 232 durch eine Oxid-Ätzung entfernt. Eine Reinigung wird anschließend durchgeführt, um bei der Photolithographie aufgebrachte Photolackreste sowie etwaige andere Verunreinigungen zu beseitigen.

In einem nachfolgenden Schritt wird eine Strukturierung der CMOS-Transistoren in dem MOS-Bereich und eine Strukturierung der Bipolartransistoren in dem Bipolar-Bereich durchgeführt.

Fig. 16 zeigt die Struktur von Fig. 15 nach dem Durchführen der CMOS-Strukturierungsschritte. In dem Kondensatorbereich wird ausgehend von der Struktur von Fig. 15 aufgrund der Prozeßführung zur Strukturierung der Transistoren Abstandhalter 242 und 244 gebildet, die seitlich an der strukturierten zweiten Polysiliziumschicht 240 angeordnet sind, wobei die strukturierte zweite Polysiliziumschicht auf eine geringere Dicke geätzt ist. Die Abstandhalter 242 und 244 sind in etwa dreieckförmig ausgebildet und bestehen aus SiO₂. Danach wird zum Erzeugen eines guten elektrischen Kontaktes eine Metall-Silizid-Schicht 246 auf der strukturierten zweiten Polysiliziumschicht 240 und eine Metall-Silizid-Schicht 248 in den Bereichen des Substrats 210, in denen keine STI-Isolationsbereiche gebildet sind, gebildet. Die Bildung der Metall-Silizid-Schichten 246 und 248 erfolgt gemäß den bekannten Verfahren zur Bildung von Metall-Silizid-Schichten. Dazu wird ein Metall, das vorzugsweise Titan umfaßt, auf der Oberfläche der strukturierten zweiten Polysiliziumschicht 240 und der Oberfläche 210a des Substrats 210 abgeschieden und in einem nachfolgenden Silizierungsprozeß mittels einer chemischen Reaktion die Metall-Silizid-Schicht gebildet. Unter Bezugnahme auf Fig. 16 ist die Metall-Silizid-Schicht 246 auf der strukturierten zweiten Polysiliziumschicht 240 angeordnet, während die Metall-Silizid-Schicht 248 in den an die Abstandhalter 242 und 244 angrenzenden Bereichen auf der Oberfläche 210a des Substrats 210 gebildet ist. Wie es in Fig. 16 zu erkennen ist, ist die Metall-Silizid-Schicht 248 in denjenigen Bereichen, in denen die STI-Isolationsbereiche angeordnet sind, nicht gebildet, um eine elektrische Isolierung durch die STI-Isolationsbereiche zu erreichen. In einem darauffolgenden Schritt wird eine isolierende Schicht 250 aus Si₃N₄ abgeschieden, so daß dieselbe auf der Metall-Silizid-Schicht 248, auf dem STI-Bereich 216, auf der Metall-Silizid-Schicht 246 und seitlich an den Abstandhaltern 242 und 244 aufgebracht ist.

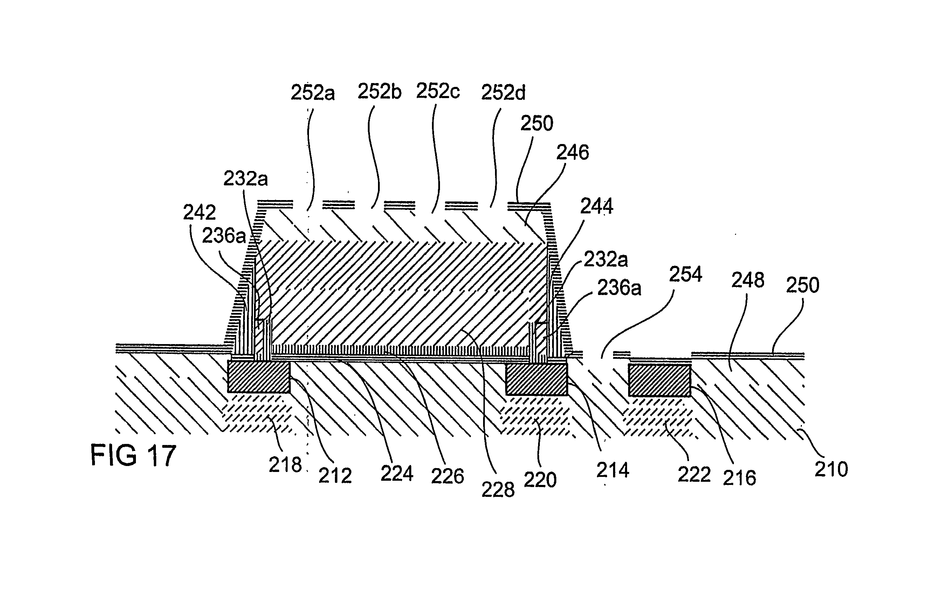

Fig. 17 zeigt die Struktur von Fig. 16 nach dem Durchführen eines weiteren Schritts, bei dem in der Silizidschicht 246 Kontaktlöcher 252a, 252b, 252c und 252d erzeugt werden. Ferner wird in der Metall-Silizid-Schicht 248, die auf dem Substrat aufgebracht ist, zumindest ein Kontaktloch 254 erzeugt, das zur Kontaktierung des Substrats dient. Die Kontaktlöcher 252a-d und 254 werden mittels Photolithographie und einer darauffolgenden Ätzung gebildet, bei der zunächst die isolierende Schicht 250 in den durch die Photolithographie definierten Bereichen entfernt wird und in die jeweils darunter liegende Silizidschicht, d.h. die Silizidschicht 246 bzw. 248, eine oder mehrere Ausnehmungen geätzt wird. In der in Fig. 17 gezeigten Struktur stellen die Kontaktlöcher 252a-d für nachfolgend in dieselbe eingebrachte Stöpsel (Plugs) einen elektrischen Kontakt von der leitfähigen strukturierten Schicht 228 über die, mit einer schwächeren Dotierung versehene zweite Polysiliziumschicht 240 und über die Silizidschicht 246 zu Leiterbahnen sicher, die in höheren Ebenen in darauffolgenden Schritten gebildet werden.

Folglich ist durch die in Fig. 17 gezeigte Struktur, die gemäß einem ersten Ausführungsbeispiel gebildet wurde, ein Kondensator hergestellt, bei dem das dotierte Substrat 210 in dem Kondensatorbereich eine untere Elektrode des Kondensators darstellt, während die strukturierte leitfähige Schicht 228, die über den strukturierten dielektrischen Schichten 224 und 226 angeordnet ist, eine obere Elektrode des Kondensators bildet. Da bei dem gebildeten Kondensator die als obere Elektrode wirkende strukturierte leitfähige Schicht 228 mit einer hohen Dotierung versehen werden kann, ohne andere Bereiche außerhalb des Kondensatorbereichs zu beeinflussen und ohne zusätzliche Phototechnikschritte zu benötigen, kann mit dem erfindungsgemäßen Verfahren ein qualitativ hochwertiger Kondensator auf eine vorteilhafte Weise hergestellt werden. Dabei werden zusätzliche Phototechnikschritte dadurch vermieden, daß die Maske 230 sowohl zum Strukturieren der leitfähigen Schicht 228 als auch zum Strukturieren der zweiten dielektrischen Schicht 226 verwendet wird.

Ferner wird die Maske 230 indirekt auch zur Strukturierung der ersten dielektrischen Schicht 224 verwendet, da bei dem Schritt der Strukturierung der ersten dielektrischen Schicht 224 die strukturierte leitfähige Schicht 228, die durch die Maske 230 strukturiert wurde, als Ätz-Maske verwendet wird.

Bei dem oben beschriebenen ersten Ausführungsbeispiel wird aufgrund der gewählten Prozeßführung die zweite Polysiliziumschicht 240 über der strukturierten leitfähigen Schicht 228 und seitlich derselben gebildet, auf der die Silizidschicht 246 aufgebracht wird. Das Vorsehen der zweiten Polysiliziumschicht 240 bietet den Vorteil, daß die strukturierte leitfähige Schicht 228 vor negativen Auswirkungen bei der Erzeugung der Silizidschicht 246 und bei einer Kontaktlochätzung derselben geschützt ist. Bei der Kontaktlochätzung der Kontaktlöcher 252a-252d bietet die aufgebrachte zweite Polysiliziumschicht 240 einen Schutz vor einem möglichen Überätzen, so daß in dem Fall des Überätzens lediglich die Polysiliziumschicht 240 geätzt wird, während die für das Verhalten des Kondensators wichtige leitfähige Schicht 228 vor dem Überätzen geschützt ist.

Ferner bietet die Polysiliziumschicht 240 allgemein einen Ätzschutz für die leitfähige Schicht 228 während des Prozeßverlaufs, wodurch etwaige Dickenänderungen durch Ätzabtragungen bei diesem Ausführungsbeispiel bei einer Aufbringung derselben nicht berücksichtigt werden müssen.

Im folgenden wird ein zweites Ausführungsbeispiel erläutert, bei dem eine Silizidschicht zur elektrischen Kontaktierung direkt auf die strukturierte leitfähige Schicht 228 aufgebracht wird, wodurch ein geringer Ohmscher Widerstand erreicht wird. Bei dem zweiten Ausführungsbeispiel werden die unter Bezugnahme auf die Fig. 3-11 erklärten Herstellungsschritte identisch zu dem ersten Ausführungsbeispiel durchgeführt. Ausgehend von der in Fig. 11 gezeigten Struktur werden daraufhin während der darauffolgenden parallelen Verfahrensschritte zur Erzeugung von aktiven Bauelementen in dem MOS-Bereich und dem Bipolar-Bereich keine weiteren Polysiliziumschichten in dem Kondensatorbereich abgeschieden. Wird die leitfähige Schicht 228 als undotierte Halbleiterschicht abgeschieden, so wird vorzugsweise nach einer Ionenimplantation der leitfähigen Schicht 228 eine Temperung durchgeführt, um eine gleichmäßige Verteilung des Dotierstoffmaterials in der leitfähigen Schicht 228 zu erreichen.

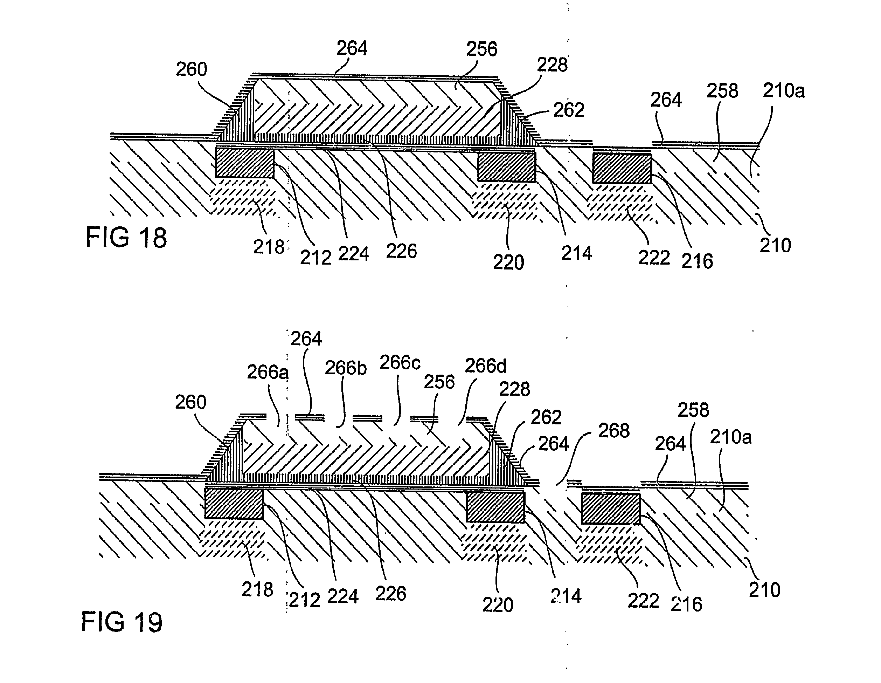

Bei dem zweiten Ausführungsbeispiel wird ausgehend von der in Fig. 11 gezeigten Struktur zunächst die Oxidschicht 232 auf dem Substrat sowie auf der strukturierten leitfähigen Schicht 228 und an den seitlichen Bereichen derselben entfernt. Daraufhin werden durch eine Silizidschichterzeugung auf der strukturierten leitfähigen Schicht 228 eine Silizidschicht 256 und auf dem Substrat eine Silizidschicht 258 gebildet. Wie bei dem ersten Ausführungsbeispiel wird die Silizidschicht 258 lediglich in Bereichen gebildet, in denen die STI-Isolierung 216 nicht angeordnet ist, um eine elektrische Isolierung, die durch den STI-Isolationsbereich 216 erreicht wird, nicht zu überbrücken. Da bei diesem Ausführungsbeispiel die strukturierte leitfähige Schicht 228 während parallel durchgeführter Prozesse zur Erzeugung der aktiven Bauelemente ohne eine schützende, darüber angeordnete Polysiliziumschicht vorliegt, ergeben sich bei diesem Ausführungsbeispiel aufgrund der Prozeßführung Abtragungen der strukturierten leitfähigen Schicht 228, die beispielsweise bei einem Schritt zur Erzeugung von Abstandhaltern 260 und 262, die seitlich an den strukturierten Schichten 224, 226, 228 und 256 angeordnet sind, auftreten. Diese Abtragungen bewirken eine Reduzierung der Dicke der strukturierten leitfähigen Schicht 228 während des weiteren Verlaufs der Prozessierung, so daß bei dem Aufbringen der leitfähigen Schicht 228 die Dickenverluste der leitfähigen Schicht 228 berücksichtigt werden müssen. Wie es ferner in Fig. 18 dargestellt ist, wird auf der Oberfläche der Silizidschicht 256 sowie an den seitlichen Oberflächen der Abstandhalter 260 und auf der Oberfläche 210a des Substrats 210 eine isolierende Schicht 264 aus Si₃N₄ abgeschieden.

Fig. 19 zeigt die in Fig. 18 dargestellte Struktur nach einem nachfolgenden Schritt, bei dem in die Silizidschicht 256 Kontaktlöcher 266a-266d und in die Silizidschicht 258 ein Kontaktloch 268 geätzt wird. Entsprechend zu dem ersten Ausführungsbeispiel werden die für die Kontaktlöcher vorgesehenen Bereiche mittels Photolithographie festgelegt und in einer darauffolgenden Ätzung zuerst die isolierende Schicht 264 in den definierten Bereichen entfernt und daraufhin die Kontaktlöcher 266a-266d durch eine Ätzung von Ausnehmungen in die Silizidschicht 256 erzeugt. Ebenso wird das Kontaktloch 268 durch das Ätzen einer Ausnehmung in der Silizidschicht 258 erzeugt.

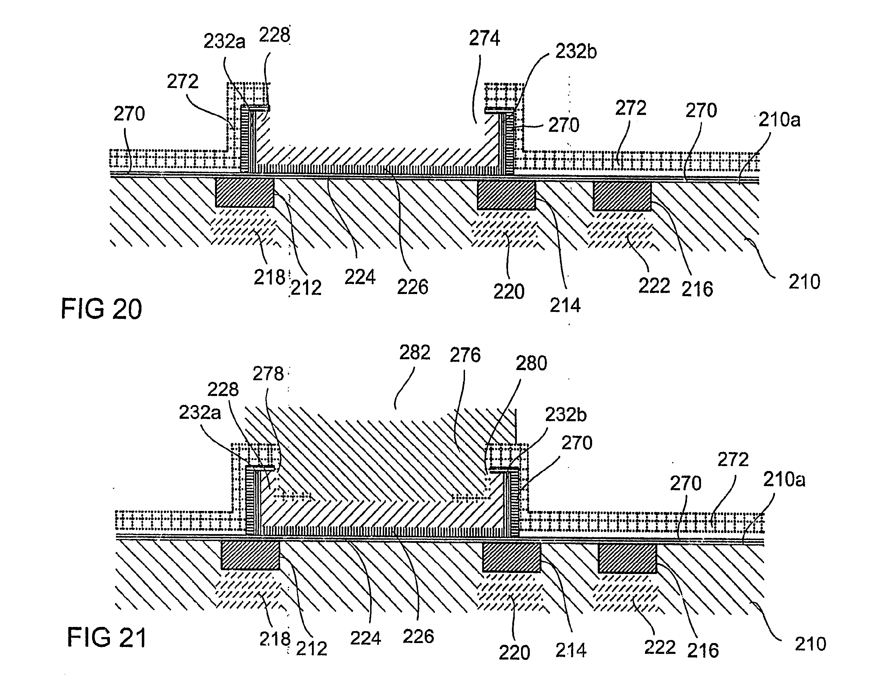

Unter Bezugnahme auf die Figuren 20 - 23 wird im folgenden ein drittes Ausführungsbeispiel erklärt, bei dem die strukturierte leitfähige Schicht 228 teilweise weggeätzt wird. Bei dem dritten Ausführungsbeispiel werden die unter Bezugnahme auf die Fig. 3-11 beschriebenen Herstellungsschritte identisch zu dem ersten und zweiten Ausführungsbeispiel durchgeführt. Ausgehend von der in Fig. 11 gezeigten Figur wird die Oxidschicht 232 bis auf Oxidschichtbereiche 232a und 232b, die jeweils seitlich an der Kondensatorstruktur 234 bestehen bleiben, weggeätzt. Daraufhin wird eine isolierende Schicht aus Si₃N₄ aufgebracht, die auf der Oberfläche 210a des Substrats 210, auf der leitfähigen Schicht 228 und auf den seitlich an der strukturierten leitfähigen Schicht 228 angeordneten Oxidschichten 232a und 232b gebildet ist. In einem darauffolgenden Schritt wird ganzflächig eine TEOS-Schicht 272 aufgebracht, so daß dieselbe auf der Oberfläche 210a des Substrats 210 sowie auf der Oxidschicht 232, die auf der strukturierten leitfähigen Schicht 228 angeordnet ist, sowie seitlich auf der isolierenden Schicht 270 gebildet ist. In einem darauffolgenden Strukturierungsprozeß, der in dem Bipolar-Bereich zum Strukturieren eines Emitterfensters verwendet wird, wird mittels geeigneter Phototechnik in dem Kondensatorbereich ein Fenster definiert, in welchem die strukturierte leitfähige Schicht 228 teilweise entfernt wird. Zuerst wird mittels des gebildeten Fensters die TEOS-Schicht 272 und die Oxidschicht 232 in dem definierten Fensterbereich entfernt. Anschließend wird die strukturierte leitfähige Schicht 228 teilweise weggeätzt, um in dem Fensterbereich eine Ausnehmung 274 in der leitfähigen Schicht 228 zu erzeugen.

Das Bilden der Ausnehmung 274 erfolgt durch die parallel in dem Bipolar-Bereich durchgeführte Emitterfenster-Ätzung, wobei diese Ätzung eine Festzeitätzung ist. Da bei dem obig erklärten dritten Ausführungsbeispiel die leitfähige Schicht 228 lediglich bis zu einer bestimmten Dicke geätzt werden soll, muß dieselbe mit einer entsprechenden Dicke aufgebracht werden, um bei der Festzeitätzung zu vermeiden, daß die strukturierte leitfähige Schicht 228 vollständig weggeätzt wird. Daher muß eine, nach dem Ätzen verbleibende Dicke der strukturierten leitfähigen Schicht 228 durch die Dicke der aufgebrachten leitfähigen Schicht 228, die vorzugsweise 170 bis 200 nm umfaßt, eingestellt werden.

Unter Bezugnahme auf Fig. 21 wird, ausgehend von der Struktur von Fig. 20, eine dotierte Polysiliziumschicht 276 zum auffüllen der Ausnehmung 274 gebildet. Die Polysiliziumschicht 276 ist ferner auf der TEOS-Schicht 272 seitlich über die Ausnehmung 274 hinaus aufgebracht. Die Polysiliziumschicht 276 wird in dem Abscheidungsprozeß gebildet, bei dem in dem Bipolarbereich eine Polysiliziumschicht zum Erzeugen eines Emitters abgeschieden wird. Die Polysiliziumschicht 276 wird dabei durch einen Strukturierungsprozeß, der eine Phototechnik mit anschließender Ätzung umfaßt, gebildet, wobei die verwendete Phototechnik in dem Bipolar-Bereich verwendet wird, um eine Strukturierung des Emitters durchzuführen. Wie es in Fig. 21 zu sehen ist, sind seitlich an der Ausnehmung 274 jeweils L-förmige TEOS-Bereiche 278 und 280 gebildet. Diese L-förmigen TEOS-Bereiche 278 und 280 werden durch den Prozeßverlauf zur Erzeugung des Bipolar-Transistors in dem Bipolar-Bereich erzeugt. Ebenso entsteht eine Ausnehmung 282 in der Polysiliziumschicht 276 aufgrund des Prozeßverlaufs zur Bildung des Bipolar-Transistors in dem Bipolar-Bereich.

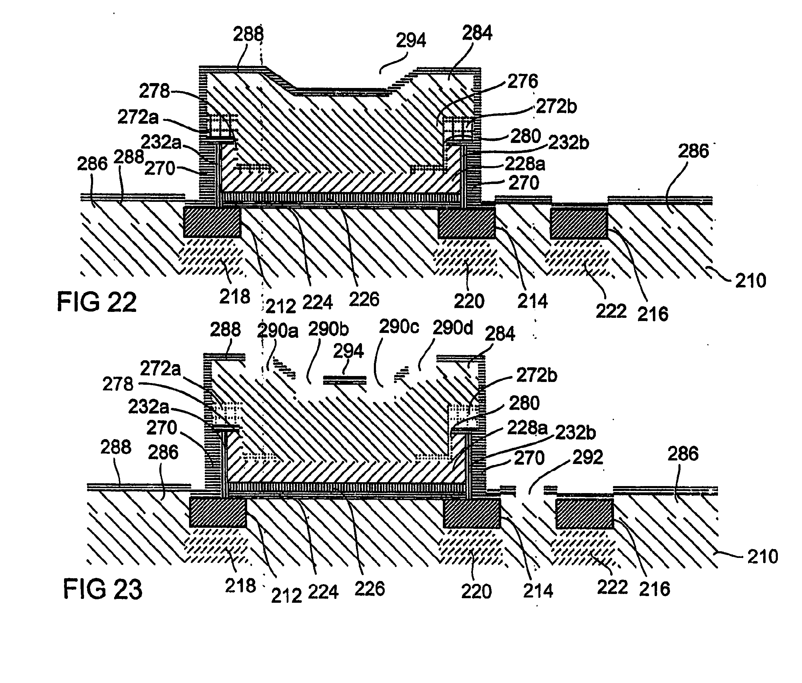

Ausgehend von der in Fig. 21 gezeigten Struktur wird unter Bezugnahme auf Fig. 22 zunächst die TEOS-Schicht 272 in den Bereichen, in denen die TEOS-Schicht 272 auf der Oberfläche 210a des Substrats 210 angeordnet ist, entfernt. In einem darauffolgenden Schritt wird eine Metall-Silizid-Schicht 284 auf der Oberfläche der Polysiliziumschicht 276 und auf dem Substrat 210 eine Metall-Silizid-Schicht 286 gebildet. Wie bei den vorhergehend beschriebenen Ausführungsbeispielen wird die Metall-Silizid-Schicht 286 nicht in den Bereichen des Substrats gebildet, in denen die STI-Isolationsbereiche, d.h. der STI-Isolationsbereich 216, gebildet ist. In einem darauffolgenden Schritt wird in der Silizidschicht 284 eine Ausnehmung 294 gebildet. Daraufhin wird ganzflächig auf der Oberfläche der Silizidschicht 284, auf der Silizidschicht 286 und auf dem STI-Isolationsbereich 216 sowie seitlich an den Schichten 284, 278, 280, 282, 270 und 272 eine isolierende Schicht 288 aus Si₃N₄ aufgebracht. In einem nachfolgenden Schritt werden in der Silizidschicht 284 Kontaktlöcher 290a-290d und in der Silizidschicht 286 zumindest ein Kontaktloch 292 erzeugt. Gemäß Fig. 23 sind die Kontaktlöcher 292b und 292c in der Mitte der Ausnehmung 294 angeordnet, wodurch sich dieselben durch die Silizidschicht 286 hindurch in die Polysiliziumschicht 278 erstrecken, wegen der größeren Höhe der Polysiliziumschichten.

Wie es in Fig. 23 zu erkennen ist, wird bei dem oben beschriebenen dritten Ausführungsbeispiel kein seitlicher Abstandhalter gebildet. Dies ergibt sich, da die Prozeßschritte, die ausgehend von der in Fig. 11 gezeigten Struktur in dem dritten Ausführungsbeispiel zur weiteren Erzeugung von Anschluß-Elementen und anderen Strukturen des Kondensators verwendet werden, Herstellungsschritte zur Erzeugung eines Bipolar-Transistors umfassen, wobei bei dieselben die Bildung eines Abstandhalters vermieden wird. Bei dem dritten Ausführungsbeispiel ist ferner zu beachten, daß aufgrund der verwendeten Herstellungsschritte nach dem Ätzen des Fensters zum Einbringen der Polysiliziumschicht 278, das parallel zum Einbringen des Emitterpolysiliziums in den Bipolar-Bereich erfolgt, zwei nachfolgende Implantantionsschritte folgen, d.h. die Kollektor-Implantation und die Basisimplantation des Bipolar-Transistors. Dabei muß darauf geachtet werden, daß bei den durchgeführten Implantantionen die dielektrischen Schichten 224 und 226 nicht beschädigt werden.

Obwohl bei den beschriebenen Ausführungsbeispielen die leitfähige Schicht 28 ein dotiertes Polysilizium-Material aufweist, ist die vorliegende Erfindung nicht darauf beschränkt. Vielmehr ist bei der vorliegenden Erfindung die Verwendung jeder geeigneten leitfähigen Schicht, wie beispielsweise eine aufgebrachte metallische Schicht, vorgesehen.

Bezugszeichenliste
- 110: Substrat
- 112: Hochleitender Bereich
- 114: STI-Graben
- 116: Erste dielektrische Schicht 118
- 118: Zweite dielektrische Schicht 120
- 120: Polysiliziumschicht
- 210: Substrat
- 210a: Oberfläche
- 212: STI-Isolationsbereich
- 214: STI-Isolationsbereich
- 216: STI-Isolationsbereich
- 218: Schwach leitfähiger Bereich
- 220: Schwach leitfähiger Bereich
- 222: Schwach leitfähiger Bereich
- 224: Erste dielektrische Schicht
- 226: Zweite dielektrische Schicht
- 228: Leitfähige Schicht
- 230: Maske
- 232: Oxidschicht
- 232a: Oxidschichtbereich
- 232b: Oxidschichtbereich
- 234: Kondensatorstruktur
- 234a: Seitenfläche
- 234b: Seitenfläche
- 236: Polysiliziumschicht
- 240: Zweite Polysiliziumschicht
- 242: Abstandhalter
- 244: Abstandhalter
- 246: Silizidschicht
- 248: Silizidschicht
- 250: Isolierende Schicht
- 252a-d: Kontaktlöcher
- 254: Kontaktloch
- 256: Silizidschicht
- 258: Silizidschicht
- 260: Abstandhalter
- 262: Abstandhalter
- 264: Isolierende Schicht
- 266a-d: Kontaktloch
- 268: Kontaktloch
- 270: Isolierende Schicht
- 272: TEOS-Schicht
- 274: Ausnehmung
- 276: Polysiliziumschicht
- 278: TEOS-Bereich
- 280: TEOS-Bereich
- 282: Ausnehmung
- 284: Silizidschicht
- 286: Silizidschicht
- 288: isolierende Schicht
- 290: Kontaktloch
- 292: Kontaktloch
- 294: Ausnehmung

## Patentansprüche

1. Verfahren zum Herstellen eines Kondensators, mit folgenden Schritten:
Bereitstellen einer Rohstruktur mit einem dotierten Substrat (210) und wenigstens einer dielektrischen Schicht (224, 226), wobei ein erster Bereich und ein zweiter Bereich des Substrats (210) durch eine elektrisch isolierende Struktur getrennt sind, wobei der erste Bereich zwischen einem ersten (212) und zweiten (214) Isolationsbereich der isolierenden Struktur angeordnet ist, wobei das dotierte Substrat (210) in dem ersten Bereich eine erste Kondensatorelektrode des Kondensators darstellt;
Aufbringen einer elektrisch leitfähigen Schicht (228) auf die wenigstens eine dielektrische Schicht (224, 226) oberhalb des ersten und zweiten Bereichs;
Aufbringen einer Maskenschicht (230) auf die elektrisch leitfähige Schicht (228) und Strukturieren derselben zur Erzeugung einer Maske (230) oberhalb des ersten Bereichs;
Wegätzen der elektrisch leitfähigen Schicht (228) und zumindest einer der wenigstens einen dielektrischen Schicht (226) im zweiten Bereich mittels der Maske, so daß die elektrisch leitfähige Schicht (228) und die zumindest eine dielektrische Schicht (226) außerhalb des ersten Bereichs entfernt wird, wodurch in dem ersten Bereich aus der leitfähigen Schicht (228) eine zweite Kondensatorelektrode und aus der dielektrischen Schicht eine strukturierte Kondensatordielektrikumsschicht gebildet ist;
Erzeugen einer Oxidschicht (232) in dem ersten und zweiten Bereich, wobei die Oxidschicht (232) in dem ersten Bereich auf einer Seitenfläche der strukturierten zweiten Kondensatorelektrode erzeugt wird; und
Fertigprozessieren eines aktiven Elements im zweiten Bereich wobei die Oxidschicht (232) in dem zweiten Bereich eine Gateoxidschicht bildet.

2. Verfahren nach Anspruch 1, bei dem die elektrisch leitfähige Schicht (228) mit einer Dicke von 80 nm bis 120 nm aufgebracht wird.

3. Verfahren nach Anspruch 1 oder 2, bei dem die elektrisch leitfähige Schicht (228) eine Mehrlagenschicht umfaßt, die mehrere Lagen mit unterschiedlichem Material umfaßt.

4. Verfahren nach Anspruch 1 oder 2, bei dem die elektrisch leitfähige Schicht (228) eine dotierte Polysiliziumschicht oder eine metallische Schicht umfaßt.

5. Verfahren nach Anspruch 4, bei dem der Schritt des Aufbringens einer elektrisch leitfähigen Schicht (228) ein Aufbringen einer undotierten Polysiliziumschicht und ein Dotieren der aufgebrachten Polysiliziumschicht umfaßt.

6. Verfahren nach einem der Ansprüche 1 bis 5, bei dem die Rohstruktur eine erste (224) und zweite (226) dielektrische Schicht umfaßt, wobei der Schritt des Wegätzens zumindest einer der wenigstens einen dielektrischen Schicht (226) im zweiten Bereich mittels der ersten Maske (230) den Schritt eines Wegätzens der zweiten dielektrischen Schicht (226) im zweiten Bereich mittels der ersten Maske (230) unter Verwendung der ersten dielektrischen Schicht (224) zum Stoppen des Ätzens.

7. Verfahren nach Anspruch 6, mit folgenden Schritten zwischen dem Schritt des Wegätzens und dem Schritt des Fertigprozessierens des aktiven Elements:
Entfernen der ersten Maske (230); und
Wegätzen der ersten dielektrischen Schicht (224) im zweiten Bereich unter Verwendung der elektrisch leitfähigen Schicht (228).

8. Verfahren nach Anspruch 6 oder 7, bei dem die erste dielektrische Schicht (224) Si₃N₄ aufweist und die zweite dielektrische Schicht (226) SiO₂ aufweist.

9. Verfahren nach einem der Ansrüche 1 bis 8, mit ferner folgendem Schritt zwischen dem Schritt eines Wegätzens der elektrisch leitfähigen Schicht (228) und dem Schritt des Fertigprozessierens eines aktiven Elements:
Erzeugen einer Kontaktstruktur (246, 252a-d; 256, 266a-d; 284, 290a-d) oberhalb der elektrisch leitfähigen Schicht.

10. Verfahren nach Anspruch 9, bei dem der Schritt des Erzeugens einer Kontaktstruktur oberhalb der elektrisch leitfähigen Schicht folgende Schritte umfaßt:
Erzeugen einer Metall-Silizid-Schicht (246; 256; 284); und
Erzeugen von Kontaktlöchern (252a-d; 266a-d; 290a-d) ) in der Metall-Silizid-Schicht (246; 256; 284).

11. Verfahren nach einem der Ansprüche 1 bis 10, mit ferner folgenden Schritten zwischen dem Schritt des Wegätzens der elektrisch leitfähigen Schicht (228) und dem Schritt des Fertigprozessierens des aktiven Elements, welches ein Bipolartransistor ist:
Aufbringen einer Polysiliziumschicht (240) in dem ersten und zweiten Bereich;
Aufbringen einer weiteren Maskenschicht auf die Polysiliziumschicht (240) und Strukturieren derselben zur Festlegung einer weiteren Maske oberhalb des ersten Bereichs und einer Maske innerhalb eines Basisbereichs des Bipolartransistors; und
Wegätzen der nicht-maskierten Bereiche.

12. Verfahren nach einem der Ansprüche 1 oder 3 bis 10, mit ferner folgenden Schritten zwischen dem Schritt des Wegätzens der elektrisch leitfähigen Schicht und dem Schritt des Fertigprozessierens des aktiven Elements, welches ein Bipolartransistor ist:
Aufbringen einer zweiten Maskenschicht und Strukturieren derselben zur Festlegung eines ersten Fensters innerhalb des ersten Bereichs, das sich teilweise über die elektrisch leitfähige Schicht (228) erstreckt, und eines zweiten Fensters innerhalb eines Emitterbereichs des Bipolartransistors;
Teilweises Wegätzen der elektrisch leitfähigen Schicht (228) und des Emitterbereichs unter Verwendung der zweiten Maskenschicht;
Aufbringen einer Polysiliziumschicht (276);
Aufbringen einer dritten Maskenschicht und Strukturieren derselben zur Erzeugung einer weiteren Maske im wesentlichen oberhalb des ersten Bereichs und oberhalb des Emitters; und
Wegätzen der nichtmaskierten Polysiliziumschicht (276).

13. Verfahren nach Anspruch 12, bei dem die elektrisch leitfähige Schicht (228) mit einer Dicke von 170 nm bis 200 nm aufgebracht wird.

## Claims

1. Method for producing a capacitor, comprising:
providing a raw structure having a doped substrate (210) and at least one dielectric layer (224, 226), wherein a first area and a second area of the substrate (210) are separated by an electrically isolating structure, wherein the first area is arranged between a first (212) and a second (214) isolating area of the isolating structure, wherein the doped substrate (210) in the first area represents a first capacitor electrode of the capacitor;
arranging an electrically conductive layer (228) on the at least one dielectric layer (224, 226) above the first and second area;
arranging a mask layer (230) on the electrically conductive layer (228) and structuring same for generating a mask (230) above the first area;
etching away the electrically conductive layer (228) and at least one of the at least one dielectric layer (226) in the second area by means of the mask, so that the electrically conductive layer (228) and the at least one dielectric layer (226) outside the first area are removed, whereby in the first area from the conductive layer (228) a second capacitor electrode and from the dielectric layer a structured capacitor dielectric layer are formed;
generating an oxide layer (232) in the first and second area, wherein the oxide layer (232) is generated in the first area on a side face of the structured second capacitor electrode; and
completing an active device in the second area, wherein the oxide layer (232) forms a gate oxide layer in the second area.

2. Method according to claim 1, wherein the electrically conductive layer (228) is arranged with a thickness of 80 nm to 120 nm.

3. Method according to claim 1 or 2, wherein the electrically conductive layer (228) comprises a multi-sheet layer, comprising several sheets with different materials.

4. Method according to claim 1 or 2, wherein the electrically conductive layer (228) comprises a doped polysilicon layer or a metallic layer.

5. Method according to claim 4, wherein the step of arranging an electrically conductive layer (228) comprises arranging an undoped polysilicon layer and doping the arranged polysilicon layer.

6. Method according to claims 1 to 5, wherein the raw structure comprises a first (224) and a second (226) dielectric layer, wherein the step of etching away at least one of the at least one dielectric layer (226) in the second area by means of the first mask (230) comprises the step of etching away the second dielectric layer (226) in the second area by means of the first mask (230) by using the first dielectric layer (224) for stopping the etching.

7. Method according to claim 6, comprising the following steps between the step of etching away and the step of completing the active device:
removing the first mask (230); and
etching away the first dielectric layer (224) in the second area by using the electrically conductive layer (228).

8. Method according to claim 6 or 7, wherein the first dielectric layer (224) comprises Si₃N₄ and the second dielectric layer (226) comprises SiO₂.

9. Method according to one of claims 1 to 8, further comprising the following step between the step of etching away the electrically conductive layer (228) and the step of completing an active device:
generating a contact structure (246, 252a-d; 256, 266a-d; 284, 290a-d) above the electrically conductive layer.

10. Method according to claim 9, wherein the step of generating a contact structure above the electrically conductive layer comprises the following steps:
generating a metal silicide layer (246; 256; 284); and
generating contact holes (252a-d; 266a-d; 290a-d) in the metal silicide layer (246; 256; 284).

11. Method according to one of claims 1 to 10, further comprising the following steps between the step of etching away the electrically conductive layer (228) and the step of completing the active device, which is a bipolar transistor:
arranging a polysilicon layer (240) in the first and second area; and
arranging a further mask layer on the polysilicon layer (240) and structuring the same for defining a further mask above the first area and a mask within a base area of the bipolar transistor;
etching away the unmasked areas.

12. Method according to one of claims 1 or 3 to 10, further comprising the following steps between the step of etching away the electrically conductive layer and the step of completing the active element, which is a bipolar transistor:
arranging a second mask layer and structuring same for defining a first window within the first area, which extends partly over the electrically conductive layer (228), and a second window within an emitter area of the bipolar transistor;
partly etching away the electrically conductive layer (228) and the emitter area by using the second masking layer;
arranging a polysilicon layer (276);
arranging a third mask layer and structuring same for generating a further mask substantially above the first area and above the emitter; and
etching away the unmasked polysilicon layer (276).

13. Method according to claim 12, wherein the electrically conductive layer (228) is arranged with a thickness of 170 nm to 200 nm.

## Revendications

1. Procédé de fabrication d'un condensateur, aux étapes suivantes consistant à :
préparer une structure brute avec un substrat dopé (210) et au moins une couche diélectrique (224, 226), une première zone et une deuxième zone du substrat (210) étant séparées par une structure électriquement isolante, la première zone étant disposée entre une première (212) et une deuxième (214) zone d'isolation de la structure isolante, le substrat dopé (210) représentant, dans la première zone, une première électrode de condensateur ;
appliquer une couche électriquement conductrice (228) sur l'au moins une couche diélectrique (224, 226) au-dessus de la première et de la deuxième zone ;
appliquer une couche de masque (230) sur la couche électriquement conductrice (228) pour générer un masque (230) au-dessus de la première zone ;
éliminer par gravure la couche électriquement conductrice (228) et au moins l'une des au moins une couche diélectrique (226) dans la deuxième zone au moyen du masque, de sorte que soient éliminées la couche électriquement conductrice (228) et l'au moins une couche diélectrique (226) en dehors de la première zone, d'où il est formé dans la première zone, à partir de la couche conductrice (228), une deuxième électrode de condensateur et, à partir de la couche diélectrique, une couche diélectrique de condensateur structurée ;
générer une couche d'oxyde (232) dans la première et la deuxième zone, la couche d'oxyde (232) dans la première zone étant générée sur une face latérale de la deuxième électrode de condensateur structurée ; et
traiter pour achever un élément actif dans la deuxième zone, la couche d'oxyde (232) dans la deuxième zone constituant une couche d'oxyde de porte.

2. Procédé selon la revendication 1, dans lequel la couche électriquement conductrice (228) est appliquée selon une épaisseur de 80 nm à 120 nm.

3. Procédé selon la revendication 1 ou 2, dans lequel la couche électriquement conductrice (228) comporte une couche multiple qui comprend plusieurs couches de matériau différent.

4. Procédé selon la revendication 1 ou 2, dans lequel la couche électriquement conductrice (228) comporte une couche de polysilicium dopée ou une couche métallique.

5. Procédé selon la revendication 4, dans lequel l'étape d'application d'une couche électriquement conductrice (228) comporte l'application d'une couche de polysilicium non dopée et le dopage de la couche de polysilicium appliquée.

6. Procédé selon l'une des revendications 1 à 5, dans lequel la structure brute comporte une première (224) et une deuxième (226) couche diélectrique, l'étape d'élimination par gravure d'au moins l'une des au moins une couche diélectrique (226) dans la deuxième zone au moyen du masque (230) comportant l'étape consistant à éliminer par gravure la deuxième couche diélectrique (226) dans la deuxième zone au moyen du premier masque (230) à l'aide de la première couche diélectrique (224) pour arrêter la gravure.

7. Procédé selon la revendication 6, aux étapes suivantes entre l'étape d'élimination par gravure et l'étape de traitement d'achèvement de l'élément actif :
éliminer le premier masque (230) ; et
éliminer par gravure la première couche diélectrique (224) dans la deuxième zone à l'aide de la couche électriquement conductrice (228).

8. Procédé selon la revendication 6 ou 7, dans lequel la première couche diélectrique (224) présente du Si₃N₄ et la deuxième couche diélectrique (226) présente du SiO₂.

9. Procédé selon l'une des revendications 1 à 8, avec, par ailleurs, l'étape suivante entre l'étape d'élimination par gravure de la couche électriquement conductrice (228) et l'étape de traitement d'achèvement d'un élément actif :
générer une structure de contact (246, 252a à d; 256, 266a à d; 284, 290a à d) au-dessus de la couche électriquement conductrice.

10. Procédé selon la revendication 9, dans lequel l'étape de génération d'une structure de contact au-dessus de la couche électriquement conductrice comporte les étapes suivantes consistant à :
générer une couche de siliciure métallique (246 ; 256 ; 284) ; et
générer des trous de contact (252a à d ; 266a à d; 290a à d) dans la couche de siliciure métallique (246 ; 256 ; 284).

11. Procédé selon l'une des revendications 1 à 10, avec, par ailleurs, les étapes suivantes entre l'étape d'élimination par gravure de la couche électriquement conductrice (228) et l'étape de traitement d'achèvement d'un élément actif, qui est un transistor bipolaire :
application d'une couche de polysilicium (240) dans la première et la deuxième zone ;
application d'une autre couche de masque sur la couche de polysilicium (240) et structuration de cette dernière pour la fixation d'un autre masque au-dessus de la première zone et d'un masque dans une zone de base du transistor bipolaire ; et
élimination par gravure des zones masquées.

12. Procédé selon l'une des revendication 1 ou 3 à 10, avec, par ailleurs, les étapes suivantes entre l'étape d'élimination par gravure de la couche électriquement conductrice et l'étape de traitement d'achèvement d'un élément actif, qui est un transistor bipolaire :
application d'une deuxième couche de masque et structuration de cette dernière pour la fixation d'une première fenêtre dans la première zone, laquelle s'étend partiellement au-dessus de la couche électriquement conductrice (228), et d'une deuxième fenêtre dans une zone d'émetteur du transistor bipolaire ;
élimination partielle par gravure de la couche électriquement conductrice (228) et de la zone d'émetteur à l'aide de la deuxième couche de masque ;
application d'une couche de polysilicium (276) ;
application d'une troisième couche de masque et structuration de cette dernière, pour générer un autre masque substantiellement au-dessus de la première zone et au-dessus de l'émetteur ; et
élimination par gravure de la couche de polysilicium non masquée (276).

13. Procédé selon la revendication 12, dans lequel la couche électriquement conductrice (228) est appliquée selon une épaisseur de 170 nm à 200 nm.
